# EUROPÄISCHE PATENTSCHRIFT

(11) **EP 3 680 908 B1**
(45) Veröffentlichungstag und Bekanntmachung des Hinweises auf die Patenterteilung: **20.08.2025**
(21) Anmeldenummer: 19217537.0
(22) Anmeldetag: 18.12.2019
(51) Int. Cl.: G11C 27/02

(54) **VORRICHTUNG ZUR BEGRENZUNG EINER VERLUSTLEISTUNG BEIM ABTASTEN EINES DIGITALEN SIGNALS**
DEVICE FOR LIMITING LOSS OF PERFORMANCE WHEN SAMPLING A DIGITAL SIGNAL
DISPOSITIF DE LIMITATION D'UNE DISSIPATION DE PUISSANCE LORS DU BALAYAGE D'UN SIGNAL NUMÉRIQUE

(30) Priorität: 09.01.2019 DE 202019100080 U
(43) Veröffentlichungstag der Anmeldung: 15.07.2020
(73) Patentinhaber: WAGO Verwaltungsgesellschaft mbH, 32423 Minden (DE)
(72) Erfinder: Patzelt, Andreas, 32257 Bünde (DE); Voß, Christian, 32427 Minden (DE)
(74) Vertreter: Koplin, Moritz

(56) Entgegenhaltungen:
- DE-T2- 69 737 573
- US-A- 5 410 269
- US-A1- 2008 150 590
- US-A1- 2011 002 062

## Beschreibung

### GEBIET

Die vorliegende Erfindung bezieht sich auf eine Vorrichtung zur Begrenzung einer Verlustleistung beim Abtasten eines digitalen Signals.

### HINTERGRUND

Aus der DE 697 37 573 T2, der US 2008/0150590 A1, der US 2011/002062 A1 und der US 5 410 269 A sind Abtast-Halte-Schaltungen bekannt.

Beim Abtasten eines digitalen Signals wird die das digitale Signal repräsentierende Spannung bzw. der das digitale Signal repräsentierende Strom zu bestimmten Zeitpunkten gemessen und einem einen Wertebereich repräsentierenden Signalwert zugeordnet, bspw. einem High-Pegel oder einem Low-Pegel.

### ZUSAMMENFASSUNG

Die Erfindung bereichert diesbezüglich den Stand der Technik, als erfindungsgemäße Vorrichtungen die Verlustleistung beim Abtasten eines digitalen Signals reduzieren, indem in Abtastpausen der Stromfluss entlang des Signalpfades verringert wird.

Eine erfindungsgemäße Vorrichtung umfasst dazu eine im Signalpfad des digitalen Signals angeordnete Schaltung, wobei die Schaltung eingerichtet ist, in Reaktion auf ein Steuersignal, das eine Abtastpause anzeigt, einen Stromfluss entlang des Signalpfads zu reduzieren, wobei die Schaltung eine Strombegrenzungsschaltung aufweist, wobei die Strombegrenzungsschaltung einen Eingangswiderstand aufweist und der Stromfluss durch die Strombegrenzungsschaltung zur Reduktion der Verlustleistung durch den Eingangswiderstand begrenzt wird.

Dabei ist unter dem Begriff "Signalpfad", wie er in der Beschreibung und den Ansprüchen verwendet wird, insbesondere eine (während des Abtastens) elektrisch leitfähige Verbindung zwischen einer das digitale Signal erzeugenden Schaltung (Sender) und einer das digitale Signal empfangenden Schaltung (Empfänger) zu verstehen, durch die die Abtastung vorgenommen wird. Bspw. kann die Schaltung einem digitalen Eingang vorgeschaltet sein und nur dann das digitale Signal "durchleiten", wenn das am Eingang anliegende Signal tatsächlich eingelesen wird.

Ferner ist unter dem Begriff "Steuersignal", wie er in der Beschreibung und den Ansprüchen verwendet wird, insbesondere ein elektrisches Signal zu verstehen, welches bspw. ein elektronisches Bauteil (z. B. einen Transistor) steuert, durch das die Schaltung von einem ersten Modus, in dem das digitale Signal (im Wesentlichen) "durchgeleitet" wird, in einen zweiten Modus umgeschaltet werden kann, in dem der Stromfluss zum Eingang reduziert wird. Das Steuersignal kann bspw. während der (Abtast-)Pausen eine erste Spannung und zu Einlesezeitpunkten eine zweite Spannung (die bspw. größer als die erste Spannung ist) aufweisen.

Zudem ist unter dem Begriff "Abtasten", wie er in der Beschreibung und den Ansprüchen verwendet wird, insbesondere ein Messen und Zuordnen eines digitalen Signals zu einem Signalwert zu verstehen. In diesem Zusammenhang ist unter dem Begriff "Abtastpause", wie er in der Beschreibung und den Ansprüchen verwendet wird, insbesondere eine Zeitspanne zu verstehen, während der kein Messen und Zuordnen eines digitalen Signals zu einem Signalwert vorgenommen wird, oder während der eine vorgenommene Zuordnung nicht weiter verwendet (d. h. ignoriert und fortlaufend überschrieben) wird.

Vorzugsweise wird die Stromaufnahme der Strombegrenzungsschaltung durch ein Schaltelement variiert, welches durch das Steuersignal gesteuert wird.

Vorzugsweise umfasst das digitale Signal Strom-/Spannungspegel in einem unteren Strom-/Spannungspegelbereich und einem oberen Strom-/Spannungspegelbereich. Dabei ist die Vorrichtung eingerichtet, das Steuersignal, das eine Abtastpause anzeigt, zu erzeugen, wenn ein Abtastwert im oberen Strom-/Spannungspegelbereich liegt und das Steuersignal, das eine Abtastpause anzeigt, nicht zu erzeugen, wenn ein Abtastwert im unteren Strom-/Spannungspegelbereich liegt.

Vorzugsweise ist die Vorrichtung eingerichtet, das digitale Signal zu bestimmten Zeitpunkten abzutasten, einen Abtastwert zu erfassen und das Steuersignal zu erzeugen, das eine Abtastpause anzeigt, wenn der Abtastwert im oberen Strom-/Spannungspegelbereich liegt, wobei der Strom-/Spannungspegel des digitalen Signals während der Abtastpause entlang des Signalpfads zur Begrenzung der Verlustleistung durch die Vorrichtung reduziert wird.

Vorzugsweise wird der Strompegel des digitalen Signals während der Abtastpause entlang des Signalpfads zur Begrenzung der Verlustleistung durch die Vorrichtung reduziert.

Die Vorrichtung umfasst vorzugsweise ferner einen Mikrocontroller und ein Speicherelement und ist eingerichtet, in Reaktion auf ein Anforderungssignal des Mikrocontrollers einen Abtastwert im Speicherelement zu speichern und nach dem Speichern eine Abtastpause anzuzeigen bis der Mikrocontroller ein nächstes Anforderungssignal erzeugt.

Vorzugsweise ist die Vorrichtung eingerichtet, das Steuersignal, das eine Abtastpause anzeigt, zu erzeugen, wenn eine Abtastpause angezeigt wird und der im Speicherelement gespeicherte Abtastwert einem High-Pegel entspricht.

Vorzugsweise umfasst die Vorrichtung ein Schaltelement, das, wenn an einem Steuereingang des Schaltelements das Steuersignal, das eine Abtastpause anzeigt, anliegt, eine elektrisch leitende Verbindung zwischen dem Signalpfad und Masse schaltet.

Vorzugsweise ist die Vorrichtung eingerichtet, während das Steuersignal die Abtastpause anzeigt, einen Abtastwert zu erzeugen und auf Basis des Abtastwerts zu bestimmen, ob die Vorrichtung fehlerhaft arbeitet.

### KURZBESCHREIBUNG DER ZEICHNUNGEN

Die Erfindung wird nachfolgend in der detaillierten Beschreibung anhand von Ausführungsbeispielen erläutert, wobei auf Zeichnungen Bezug genommen wird, in denen:
Fig. 1 ein Blockschaltbild einer erfindungsgemäßen Vorrichtung;
Fig. 2 ein Blockschaltbild einer weiteren erfindungsgemäßen Vorrichtung;
Fig. 3 ein Schaltbild einer in einer erfindungsgemäßen Vorrichtung umfassten Strombegrenzungsschaltung;
Fig. 4 einen Prozess zum Aufdecken von Fehlern;
Fig. 5 eine Vorgehensweise beim Erzeugen des Steuersignals; und
Fig. 6 eine weitere Vorgehensweise beim Erzeugen des Steuersignals zeigt. Dabei sind in den Zeichnungen gleiche oder funktional ähnliche Elemente durch gleiche Bezugszeichen gekennzeichnet.

### DETAILLIERTE BESCHREIBUNG

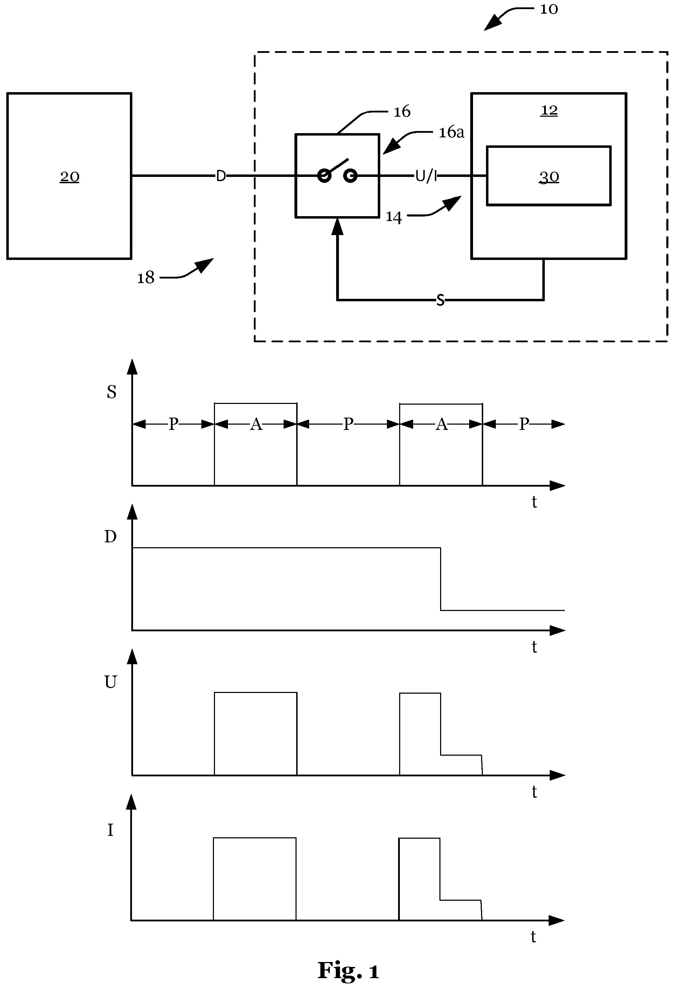

Fig. 1 zeigt ein Blockschaltbild einer Vorrichtung 10, die nicht unter den Gegenstand der Ansprüche fällt. Die Vorrichtung 10 umfasst einen Empfänger 12 (bspw. einen Mikrocontroller) und eine einem Eingang 14 des Empfängers 12 vorgeschaltete Schaltung 16. Die Schaltung 16 ist eingerichtet, in Reaktion auf ein Steuersignal S des Empfängers 12, das eine Abtastpause P anzeigt, einen Stromfluss I entlang des Signalpfads 18 zu reduzieren, indem der Signalpfad 18 mittels eines Schalters 16a unterbrochen wird. Dadurch kann die Verlustleistung beim Abtasten eines digitalen Signals D, das von einem Sender 20 ausgegeben wird, reduziert werden.

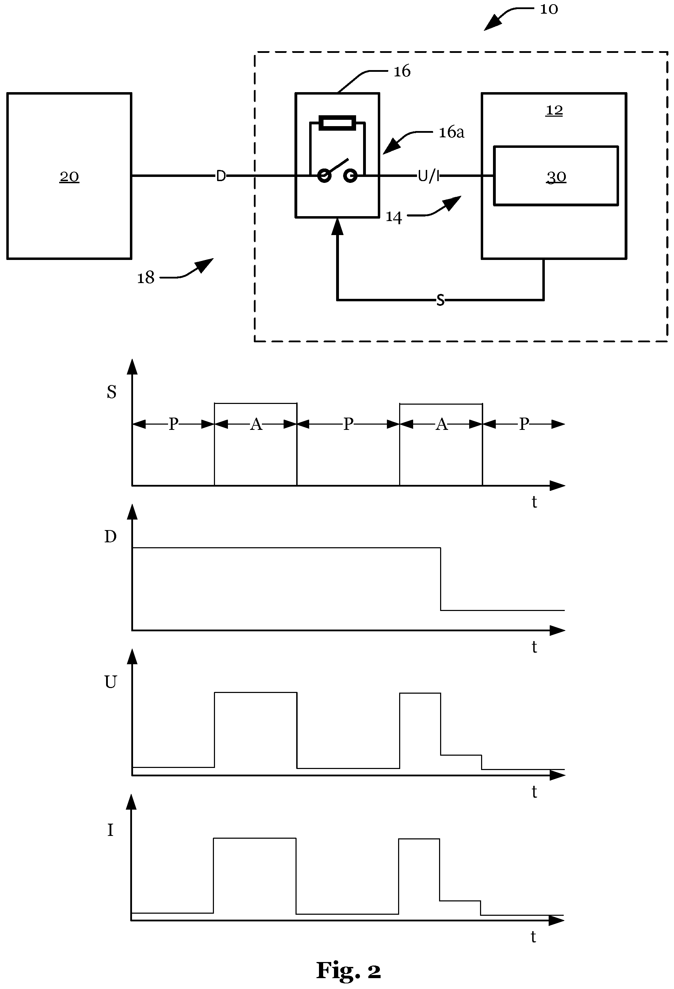

Dieses Vorgehen ist insbesondere dann vorteilhaft, wenn ein Abschalten des Senders 20 (bspw. eines Sensors) in Abtastpausen P nicht möglich/sinnvoll ist, bspw. weil der Sender 20 eine konstante Energieversorgung benötigt, um korrekt zu funktionieren. Erfindungsgemäß ist, wie in Fig. 2 gezeigt, parallel zum Schalter 16a ein Widerstand angeordnet, so dass der Stromfluss auch während der Abtastpausen P nicht gänzlich versiegt und der Eingang 14 auch in Abtastpausen P nicht stromlos wird. Der eingelesene Abtastwert kann dann in einem Speicherelement 30 des Empfängers 12 gespeichert werden, wobei der Speicherelement 30 bei jedem Abtasten mit einem neuen (aktuellen) Wert überschrieben werden kann. Der Empfänger 12 kann zudem den Abtastwert jederzeit aus dem Speicherelement 30 auslesen und weiterverarbeiten.

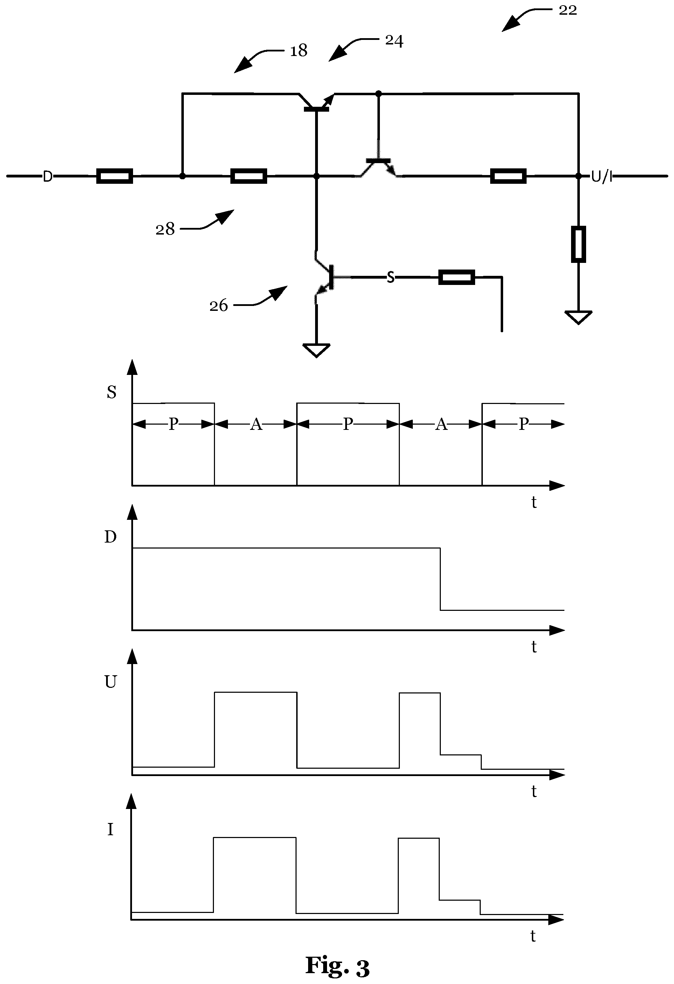

Fig. 3 zeigt ein Schaltbild einer möglichen Ausgestaltung einer in einer erfindungsgemäßen Vorrichtung 10 umfassten Strombegrenzungsschaltung 22. Die Strombegrenzungsschaltung 22 umfasst einen im Signalpfad platzierten ersten Transistor 24, der mittels eines Steuersignals S geöffnet und geschlossen werden kann. So wird, wenn an eine Basis eines zweiten Transistors 26 eine ausreichend hohe Schaltspannung angelegt wird, dieser leitend, wodurch die an der Basis des ersten Transistors 24 anliegende Spannung reduziert wird. Durch die reduzierte Basisspannung wird der erste Transistor 24 hochohmig und der Stromfluss I durch den ersten Transistor 24 reduziert (Abtastpause P).

Wird hingegen während einer Abtastphase A die an der Basis des zweiten Transistors 26 anliegende Spannung reduziert, wird der zweite Transistor 26 hochohmig, wodurch sich die an der Basis des ersten Transistors 24 anliegende Spannung erhöht. Dadurch wird der erste Transistor 24 niederohmig und der Stromfluss I durch den ersten Transistor 24 erhöht. Der sich einstellende Stromfluss I durch den ersten Transistor 24 kann dabei mittels Dimensionierung des Widerstandes 28 an den Eingang 14 des Empfängers 12 angepasst werden. So kann bspw. eine Eingangsspannung von 220 Volt in eine Ausgangsspannung von 11 Volt gewandelt werden, wodurch der Eingang 14 mit weniger leistungsfähigen Bauteilen realisiert werden kann.

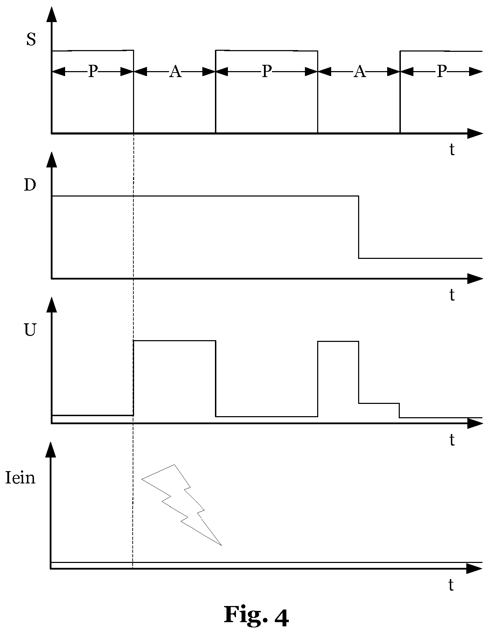

Zudem kann, wie in Fig. 4 illustriert, überprüft werden, ob der Eingang 14 des Empfängers 12 korrekt funktioniert. Zeigt sich bspw. trotz des Umschaltens zwischen Abtastpausen P und Abtastphasen A keine Änderung des vom Empfänger 12 eingelesenen Signals Iein kann daraus geschlossen werden, dass der Eingang 14 des Empfängers 12 nicht korrekt funktioniert. Dies kann insbesondere bei sicherheitsgerichteten Empfängern 12 vorteilhaft sein.

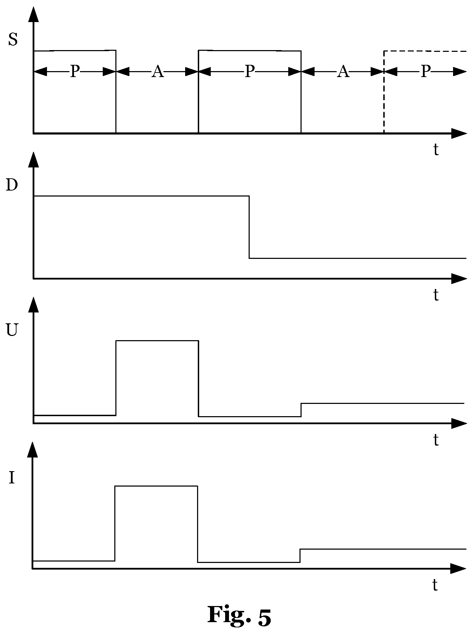

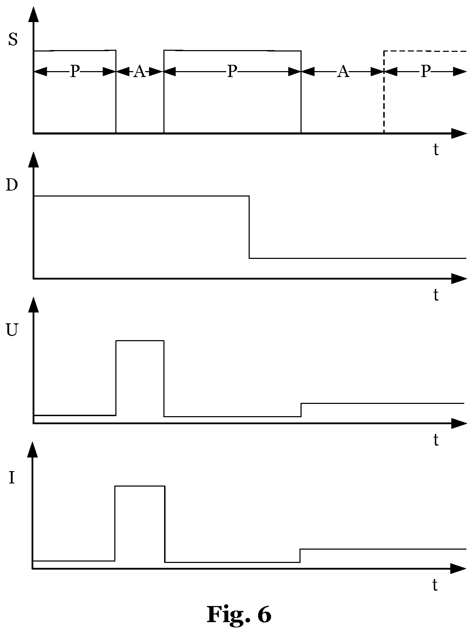

Ferner kann, wie in Fig. 5 illustriert, das Anzeigen einzelner Abtastpausen P (mittels des Steuersignals S) unterdrückt werden, wenn der Abtastwert Iein einem Low-Pegel entspricht. Dadurch kann der Schaltaufwand ohne wesentliche Steigerung der Verlustleistung reduziert werden, da bei einem Low-Pegel, bei dem der Strom-/Spannungspegel des digitalen Signals D in einem unteren Strom-/Spannungspegelbereich liegt, wesentlich weniger Verlustleistung auftritt, als bei einem High-Pegel, in dem das digitale Signal in einem oberen Strom-/Spannungspegelbereich liegt. Zudem kann, wie in Fig. 6 gezeigt, eine Abtastphase A sofort dann beendet werden, wenn ein High-Pegel eingelesen und in dem Speicher 30 des Empfängers 12 gespeichert worden ist, wodurch die Verlustleistung noch weiter reduziert werden kann.

### BEZUGSZEICHENLISTE

- 10: Vorrichtung
- 12: Empfänger (Mikrocontroller)
- 14: Eingang
- 16: Schaltung
- 18: Signalpfad
- 20: Sender (Sensor)
- 22: Strombegrenzungsschaltung
- 24: Transistor
- 26: Transistor
- 28: Widerstand
- 30: Speicherelement
- A: Abtastphase
- D: Digitales Signal
- I: Stromfluss
- P: Abtastpause
- S: Steuersignal
- U1: Eingangsspannung
- U2: Ausgangsspannung

## Patentansprüche

1. Vorrichtung (10) zur Begrenzung einer Verlustleistung beim Abtasten eines digitalen Signals (D), umfassend eine im Signalpfad (18) des digitalen Signals (D) angeordnete Schaltung (16), wobei die Schaltung (16) eingerichtet ist, in Reaktion auf ein Steuersignal (S), das eine Abtastpause (P) anzeigt, einen Stromfluss (I) entlang des Signalpfads (18) zu reduzieren, wobei die Schaltung eine Strombegrenzungsschaltung (22) aufweist, **dadurch gekennzeichnet, dass** die Strombegrenzungsschaltung (22) einen Eingangswiderstand (28) aufweist und der Stromfluss (I) durch die Strombegrenzungsschaltung (22) zur Reduktion der Verlustleistung durch den Eingangswiderstand (28) begrenzt wird.

2. Vorrichtung (10) nach Anspruch 1, wobei die Stromaufnahme der Strombegrenzungsschaltung (22) durch ein Schaltelement variiert wird, welches durch das Steuersignal gesteuert wird.

3. Vorrichtung (10) nach Anspruch 1 oder 2, wobei das digitale Signal (D) Strom-/Spannungspegel in einem unteren Strom-/Spannungspegelbereich und einem oberen Strom-/Spannungspegelbereich umfasst und die Vorrichtung eingerichtet ist, das Steuersignal (S), das eine Abtastpause (P) anzeigt, zu erzeugen, wenn ein Abtastwert im oberen Strom-/Spannungspegelbereich liegt und das Steuersignal (S), das eine Abtastpause (P) anzeigt, nicht zu erzeugen, wenn ein Abtastwert im unteren Strom-/Spannungspegelbereich liegt.

4. Vorrichtung (10) nach Anspruch 3, wobei die Vorrichtung (10) eingerichtet ist, das digitale Signal (D) zu bestimmten Zeitpunkten abzutasten, einen Abtastwert zu erfassen und das Steuersignal (S) zu erzeugen, das eine Abtastpause anzeigt, wenn der Abtastwert im oberen Strom-/Spannungspegelbereich liegt, wobei der Strom-/Spannungspegel des digitalen Signals (D) während der Abtastpause (P) entlang des Signalpfads (18) zur Begrenzung der Verlustleistung durch die Vorrichtung (10) reduziert wird.

5. Vorrichtung (10) nach Anspruch 4, wobei der Strompegel des digitalen Signals (D) während der Abtastpause (P) entlang des Signalpfads (18) zur Begrenzung der Verlustleistung durch die Vorrichtung (10) reduziert wird.

6. Vorrichtung (10) nach einem der Ansprüche 1 bis 5, ferner umfassend:
einen Mikrocontroller (12); und
ein Speicherelement (30);
wobei die Vorrichtung (10) eingerichtet ist, in Reaktion auf ein Anforderungssignal des Mikrocontrollers (12) einen Abtastwert im Speicherelement (30) zu speichern und nach dem Speichern eine Abtastpause (P) anzuzeigen bis der Mikrocontroller (12) ein nächstes Anforderungssignal erzeugt.

7. Vorrichtung (10) nach Anspruch 6, wobei die Vorrichtung (10) eingerichtet ist, das Steuersignal (S), das eine Abtastpause (P) anzeigt, zu erzeugen, wenn eine Abtastpause (P) angezeigt wird und der im Speicherelement (30) gespeicherte Abtastwert einem High-Pegel entspricht.

8. Vorrichtung (10) nach einem der Ansprüche 1 bis 7, wobei die Vorrichtung (10) ein Schaltelement umfasst, das, wenn an einem Steuereingang des Schaltelements das Steuersignal (S), das eine Abtastpause (P) anzeigt, anliegt, eine elektrisch leitende Verbindung zwischen dem Signalpfad (18) und Masse schaltet.

9. Vorrichtung (10) nach einem der Ansprüche 1 bis 8, wobei die Vorrichtung (10) eingerichtet ist, während das Steuersignal (S) die Abtastpause (P) anzeigt, einen Abtastwert zu erzeugen und auf Basis des Abtastwerts zu bestimmen, ob die Vorrichtung (10) fehlerhaft arbeitet.

## Claims

1. Device (10) for limiting a loss of performance when sampling a digital signal (D), comprising a circuit (16) arranged in the signal path (18) of the digital signal (D), wherein the circuit (16) is configured to reduce a current flow (I) along the signal path (18) in response to a control signal (S), which indicates a sampling pause (P), wherein the circuit has a current limiting circuit (22), **characterized in that** the current limiting circuit (22) has an input resistor (28) and the current flow (I) is limited by the current limiting circuit (22) to reduce the loss of performance through the input resistor (28).

2. Device (10) according to claim 1, wherein the power consumption of the current limiting circuit (22) is varied by a switching element, which is controlled by the control signal.

3. Device (10) according to claim 1 or 2, wherein the digital signal (D) comprises current/voltage levels in a lower current/voltage level range and an upper current/voltage level range and the device is configured to generate the control signal (S), which indicates a sampling pause (P), when a sample value is in the upper current/voltage level range and not to generate the control signal (S), which indicates a sampling pause (P), when a sample value is in the lower current/voltage level range.

4. Device (10) according to claim 3, wherein the device (10) is configured to sample the digital signal (D) at certain times, to record a sample value and to generate the control signal (S), which indicates a sampling pause, when the sample value is in the upper current/voltage level range, wherein the current/voltage level of the digital signal (D) is reduced during the sampling pause (P) along the signal path (18) to limit the loss of performance by the device (10).

5. Device (10) according to claim 4, wherein the current level of the digital signal (D) is reduced during the sampling pause (P) along the signal path (18) to limit the loss of performance by the device (10).

6. Device (10) according to any one of claims 1 to 5, further comprising:
a microcontroller (12), and
a memory element (30),
wherein the device (10) is configured to store a sample value in the memory element (30), in response to a request signal from the microcontroller (12), and to indicate a sampling pause (P) after storage until the microcontroller (12) generates a subsequent request signal.

7. Device (10) according to claim 6, wherein the device (10) is configured to generate the control signal (S), which indicates a sampling pause (P), when a sampling pause (P) is indicated and the sample value stored in the memory element (30) corresponds to a high level.

8. Device (10) according to any one of claims 1 to 7, wherein the device (10) comprises a switching element, which switches an electrically conductive connection between the signal path (18) and the ground when the control signal (S), which indicates a sampling pause (P), is present at a control input of the switching element.

9. Device (10) according to any one of claims 1 to 8, wherein the device (10) is configured to generate a sample value, while the control signal (S) indicates the sampling pause (P), and to determine whether the device (10) is malfunctioning, on the basis of the sample value.

## Revendications

1. Dispositif (10) de limitation d'une dissipation de puissance lors du balayage d'un signal (D) numérique, comprenant un circuit (16) agencé dans le chemin du signal (18) du signal (D) numérique, dans lequel le circuit (16) est conçu afin de réduire en réaction à un signal de commande (S) qui indique une pause de balayage (P), un flux de courant (1) le long du chemin de signal (18), dans lequel le circuit présente un circuit de limitation de courant (22), **caractérisé en ce que** le circuit de limitation de courant (22) présente une résistance d'entrée (28) et le flux de courant (I) est limité par le circuit de limitation de courant (22) pour la réduction de la dissipation de puissance par la résistance d'entrée (28).

2. Dispositif (10) selon la revendication 1, dans lequel la consommation de courant du circuit de limitation de courant (22) est variée par un élément de commutation qui est commandé par le signal de commande.

3. Dispositif (10) selon la revendication 1 ou 2, dans lequel le signal (D) numérique comprend un niveau de courant/de tension dans une zone de niveau de courant/de tension inférieure et dans une zone de niveau de courant/de tension supérieure et le dispositif est conçu afin de générer le signal de commande (S) qui indique une pause de balayage (P) lorsqu'une valeur de balayage se trouve dans la zone de niveau de courant/de tension supérieure et de ne pas générer le signal de commande (S) qui indique une pause de balayage (P) lorsqu'une valeur de balayage se trouve dans une zone de niveau de courant/de tension inférieure.

4. Dispositif (10) selon la revendication 3, dans lequel le dispositif (10) est conçu afin de balayer le signal (D) numérique à des moments déterminés, de détecter une valeur de balayage et de générer le signal de commande (S) qui indique une pause de balayage lorsque la valeur de balayage se trouve dans la zone de niveau de courant/de tension supérieure, dans lequel le niveau de courant/de tension du signal (D) numérique est réduit pendant la pause de balayage (P) le long du chemin de signal (18) pour la limitation de la dissipation de puissance par le dispositif (10).

5. Dispositif (10) selon la revendication 4, dans lequel le niveau de courant du signal (D) numérique est réduit pendant la pause de balayage (P) le long du chemin de signal (18) pour la limitation de la dissipation de puissance par le dispositif (10).

6. Dispositif (10) selon l'une quelconque des revendications 1 à 5, comprenant de plus :
un microcontrôleur (12) ; et
un élément de mémoire (30) ;
dans lequel le dispositif (10) est conçu afin d'enregistrer en réaction à un signal de demande du microcontrôleur (12) une valeur de balayage dans l'élément de mémoire (30) et d'indiquer après l'enregistrement une pause de balayage (P) jusqu'à ce que le microcontrôleur (12) génère un signal de demande suivant.

7. Dispositif (10) selon la revendication 6, dans lequel le dispositif (10) est conçu afin de générer le signal de commande (S) qui indique une pause de balayage (P) lorsqu'une pause de balayage (P) est indiquée et la valeur de balayage enregistrée dans l'élément de mémoire (30) correspond à un niveau élevé.

8. Dispositif (10) selon l'une quelconque des revendications 1 à 7, dans lequel le dispositif (10) comprend un élément de commutation qui, lorsque le signal de commande (S) qui indique une pause de balayage (P), est appliqué au niveau d'une entrée de commande de l'élément de commutation, commute une liaison électroconductrice entre le chemin de signal (18) et la masse.

9. Dispositif (10) selon l'une quelconque des revendications 1 à 8, dans lequel le dispositif (10) est conçu afin de générer une valeur de balayage alors que le signal de commande (S) indique la pause de balayage (P) et de déterminer sur la base de la valeur de balayage si le dispositif (10) travaille de manière incorrecte.
